Europäisches Patentamt

European Patent Office

Office européen des brevets

(11) Veröffentlichungsnummer: **0 428 764 B1**

(12) **EUROPÄISCHE PATENTSCHRIFT**

(45) Veröffentlichungstag der Patentschrift: **20.04.94**

(21) Anmeldenummer: **89121401.7**

(22) Anmeldetag: **18.11.89**

(51) Int. Cl.⁵: **H04N 5/92**

(54) Digitaler Begrenzer zur Pegelbegrenzung eines in Digitalform vorliegenden Videosignals.

(43) Veröffentlichungstag der Anmeldung:
**29.05.91 Patentblatt  91/22**

(45) Bekanntmachung des Hinweises auf die Patenterteilung:
**20.04.94 Patentblatt  94/16**

(84) Benannte Vertragsstaaten:
**DE FR NL**

(56) Entgegenhaltungen:
**EP-A- 0 106 000**
**EP-A- 0 343 892**

**PATENT ABSTRACTS OF JAPAN Band 9, Nr. 291 (E-359)(2014), 19. November 1985; JP-A-60130987 (NIPPON VICTOR K.K.) 12.07.1985**

(73) Patentinhaber: **Deutsche ITT Industries GmbH**
**Hans-Bunte-Strasse 19**
**D-79108 Freiburg(DE)**

(72) Erfinder: **Flamm, Peter Michael**
**Hinterhöfen 9**
**D-7806 March-Buchheim(DE)**

Rank Xerox (UK) Business Services
(3.10/3.09/3.3.3)

**Beschreibung**

Die Erfindung betrifft ein Verfahren und eine Vorrichtung zur Pegelbegrenzung eines in digitaler Form vorliegenden Videosignals.

Seit digitale integrierte Schaltungen verfügbar sind, die sich mit genügend hohen Taktfolgefrequenzen betreiben lassen, hat die Digitalisierung der Video-Signalverarbeitung in Fernsehempfängern und Videokassettenrecordern (VCR) Eintritt gefunden. Wie dem "Elektronik-Sonderheft", Nr. 57, 1984, Seiten 97-100 entnehmbar ist, wird bei Videokassettenrecordern die Luminanzinformation von dem ursprünglich amplitudenmodulierten FBAS-Signal zur Aufzeichnung auf das Magnetband in ein frequenzmoduliertes Signal umgewandelt, um die höhere Störunempfindlichkeit von frequenzmodulierten Signalen zu nutzen. Im Zusammehang mit der Frequenzmodulation wird eine Preemphasis durchgeführt, mittels welcher eine Anhebung der hohen Frequenzen des Videosignals durchgeführt wird, bevor es auf den Frequenzmodulator gelangt. Luminanzsprünge, wie sie in einem Fernsehbild bei schlagartigem Übergang von Schwarz nach Weiß auftreten, beispielsweise bei der Darstellung scharfer Konturen von Gegenständen, enthalten hohe Frequenzanteile. Diese würden bei der Preemphasis-Anhebung zu entsprechend hohen momentanen Frequenzen des frequenzmodulierten Signals führen. Einerseits ist die Aufzeichnung derart hoher Frequenzen auf Magnetband problematisch. Außerdem würde der Frequenzmodulator durch derartig hochfrequente Signalanteile übersteuert.

Um diese Probleme zu vermeiden, ist eine Signalbegrenzung vor dem Preemphasis-Vorgang erforderlich.

Im Wiedergabeteil des Videorecorders wird eine Deemphasis durchgeführt, die der im Aufnahmeteil vorgenommenen Preemphasis komplementär entgegenwirkt, um eine möglichst unverfälschte Wiedergabe der aufgezeichneten Videoinformation zu erreichen. Bei dem Deemphasis-Vorgang werden hohe Frequenzanteile entsprechend abgesenkt.

Durch die Begrenzung vor der Preemphase kommt es zu einer Verfälschung der aufzuzeichnenden Videoinformation. Die Folge davon ist, daß beispielsweise ein Schwarz-Weiß-Sprung bei der Wiedergabe nicht sauber auf dem Bildschirm wiedergegeben wird, sondern nur in kontrastarmer, verschliffener Form.

Der Erfindung liegt die Aufgabe zugrunde, bei digital verarbeiteten Videosignalen den durch die digitale Begrenzung verursachten Problemen entgegenzuwirken.

Verfahrensmäßige und vorrichtungsmäßige Lösungen sind im Anspruch 1 bzw. 9 angegeben.

Weiterbildungen dieser Lösungen geben die abhängigen Ansprüche an.

Bei der erfindungsemäßen Methode wird auf digitale Weise erreicht, daß der bei der Begrenzung abgeschnittene Informationsteil nicht verloren geht, sondern aufgrund einer Gedächtnisfunktion im Begrenzerbereich nach Beendigung des Begrenzungseinsatzes noch zur Verfügung steht und dem Videosignal zur weiteren Verarbeitung mitgegeben wird. Die Folge davon ist eine deutliche Qualitätsverbesserung der beim Wiedergabevorgang auf dem Bildschirm dargestellten Bildinformation. Ein Schwarz-Weiß-Sprung in der Bildinformation wird mit viel stärkerem Kontrast als ohne die erfindungsgemäße Begrenzungsmethode dargestellt.

Die Gedächtnisfunktion für das digital begrenzte digitale Videosignal wird dadurch erreicht, daß ab dem Begrenzungseinsatz in digitaler Form die Differenz zwischen Begrenzereingangssignal und Begrenzerausgangssignal gebildet und das resultierende Differenzsignal mit Hilfe eines Akkumulators zeitlich akkumuliert oder integriert wird und daß einerseits ein Teil des akkumulierten Signals zu dem dem Begrenzer zuzuführenden Videosignal hinzuaddiert und andererseits ein Teil des akkumulierten Signals von dem zu akkumulierenden Signal subtrahiert wird. Mindestens der zu subtrahierende Teil ist ein Bruchteil des akkumulierten Signals. Vorzugsweise gilt dies auch für den Teil des akkumulierten Signals, das dem dem Begrenzer zuzuführenden Videosignal hinzuaddiert wird.

Findet keine Begrenzung statt, gibt es kein Differenzsignal, das akkumuliert werden kann. Dann wird auch dem dem Begrenzer zuzuführenden Videosignal kein weiterer Signalanteil hinzuaddiert. Findet eine Begrenzung des digitalen Videosignals statt, entsteht ein Differenzsignal, das zeitlich akkumuliert oder integriert wird, so daß das akkumulierte Signal Dauer und Stärke des bei der Begrenzung abgeschnittenen Videosignalteils repräsentiert. Auch wenn die Begrenzung und damit das Differenzsignal aufhören, wird weiterhin ein Teil des akkummulierten Signals dem dem Begrenzer zugeführten Videosignal hinzuaddiert, wobei dieser Teil umso größer ist, je länger die Begrenzung dauerte und je stärker das begrenzte Signal die Begrenzungsschwelle überschritten hat. Da ein Bruchteil des akkumulierten Signals mit negativem Vorzeichen auf den Eingang des Akkumulators zurückgeführt wird, läuft der Akkumulator langsam leer, nachdem der Begrenzungsvorgang beendet worden ist. Die Gedächtnisfunktion geht somit nach einer Zeitdauer zu Ende, die von der Stärke des akkumulierten Signals abhängt.

Mit der Erfindung ist es gelungen, eine solche Gedächtnisfunktion auf digitale Weise und bei der Verarbeitung digitaler Videosignale zu verwirklichen. Da für die Bildung der Teile des akkumulierten Signals, die zu dem dem Begrenzer zuzuführenden Videosignal hinzuaddiert bzw. von dem zu akkumulierenden Signal subtrahiert werden, Multiplizierstufen verwendet werden können, die einen bestimmten Koeffizienten des akkumulierten Signals bilden, kann man auf sehr einfache Weise eine hohe Flexibilität bei der Bestimmung der genannten Teile des akkumulierten Signals erreichen.

Auch bei der Begrenzerfunktion hat man aufgrund der digitalen Signalverarbeitung hohe Flexibilität. Beispiels- und vorzugsweise wird die Begrenzerfunktion durch eine ROM-Tabelle gebildet. Durch einfaches Programmieren des diese Tabelle enthaltenden ROM kann man nach Belieben weiche Begrenzungseinsätzes gewünschter Art realisieren.

Vorzugsweise führt man das Differenzsignal über eine weitere Multiplizierstufe auf die Akkumulierstufe, um weitere Flexibilität bei der Gestaltung der Gedächtnisfunktion zu haben.

Weitere Einzelheiten und Aspekte der Erfindung werden nun anhand einer Ausführungsform der Erfindung näher erläutert. In zugehörigen Zeichnungen zeigen:

Fig. 1    ein Blockschaltbild einer bevorzugten Ausführungsform eines erfindungsgemäßen digitalen Begrenzers;

Fig. 2    ein Beispiel eines dem Begrenzer nach Fig. 1 zugeführten Eingangssignals; und

Fig. 3    das zugehörige Ausgangssignal des Begrenzers nach Fig. 1.

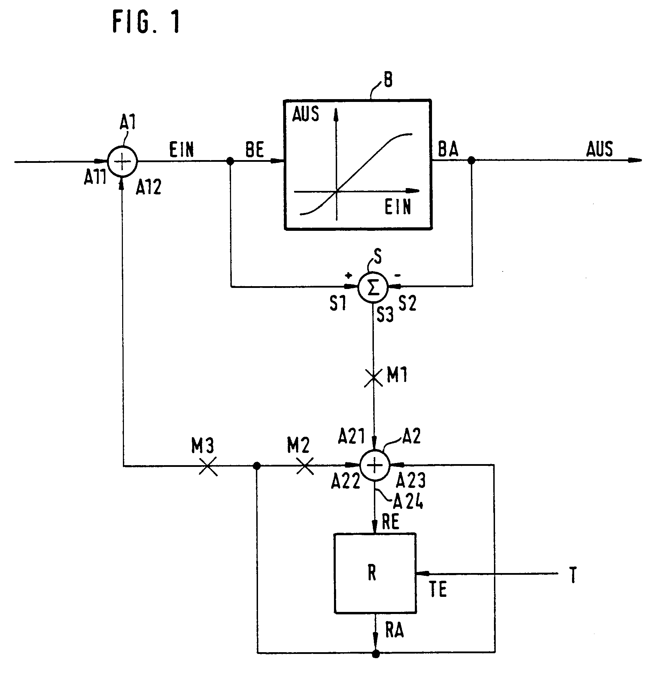

Die in Fig. 1 gezeigte Ausführungsform eines erfindungsgemäßen digitalen Begrenzers umfaßt eine Begrenzerstufe B mit einem Begrenzereingang BE und einem Begrenzerausgang BA. Dem Begrenzereingang BE ist eine erste Addierstufe A1 vorgeschaltet, die einen ersten Eingang A11 und einen zweiten Eingang A12 aufweist. Eine Subtrahierstufe S weist einen ersten Eingang S1 für ein zu addierendes Signal und einen zweiten Eingang S2 für ein zu subtrahierendes Signal auf. Der addierende Eingang S1 und der subtrahierende Eingang S2 sind mit dem Eingang BE bzw. dem Ausgang BA der Begrenzerstufe B verbunden. Ein Ausgang S3 der Subtrahierstufe S ist über eine erste Multiplizierstufe M1 mit einem ersten Eingang A21 einer zweiten Addierstufe A2 verbunden. Die Addierstufe A2 weist einen zweiten Eingang A22 und einen dritten Eingang A23 auf. Ein Ausgang A24 des zweiten Addierers A2 ist mit einem Eingang RE eines Registers R verbunden. Ein Ausgang RA des Registers R ist mit dem Eingang A23 des zweiten Addierers A2 direkt und mit dessen Eingang A22 über eine zweite Multiplizierstufe M2 verbunden. Der Ausgang RA ist außerdem über eine dritte Multiplizierstufe M3 mit dem zweiten Eingang A12 der ersten Addierstufe A1 verbunden. Das Register weist einen Takteingang TE auf, über welchen dem Register R ein Takt T zugeführt wird.

Die Begrenzerstufe B weist beispielsweise eine Begrenzungskennlinie auf, wie sie in dem Block des Begrenzers B dargestellt ist. Sowohl für positive als auch für negative Eingangssignale verläuft die Begrenzungskennlinie zunächst linear mit einem Anstiegswinkel von 45°. D.h., in diesem Bereich hat die Begrenzungsstufe B eine Verstärkung von 1. Beim Erreichen einer positiven bzw. negativen Begrenzungsschwelle geht die Begrenzungskennlinie mit einem weichen Übergang in einen zur Abszisse parallel verlaufenden Kennlinienbereich über.

Der in Fig. 1 gezeigte Begrenzer ist ein digitaler Begrenzer. Dem Eingang A11 der ersten Addierstufe A1 wird ein Videosignal in Digitalform zugeführt. Die Begrenzungsstufe B muß somit ein digitales Signal verarbeiten. Vorzugsweise wird sie durch eine ROM-Tabelle realisiert. In dieser ROM-Tabelle wird zu jedem Videosignalwert, der dem Eingang BE zugeführt werden kann, ein Ausgangssignalwert zugeordnet, der am Ausgang BA abgegeben wird. Solange sich die Werte des Videosignals im nicht begrenzenden Bereich der Begrenzungskennlinie befinden, stimmen die Signalwerte am Ausgang BA und am Eingang BE überein. In diesem Fall werden den beiden Eingängen S1 und S2 der Subtrahierstufe S gleiche Signalwerte zugeführt. An ihrem Ausgang S3 erscheint daher kein Ausgangssignal.

Ist der Begrenzungseinsatz der Begrenzungsstufe B erreicht, bleibt das Ausgangssignal am Ausgang BA zunehmend hinter dem Eingangssignal am Eingang Be zurück. Als Folge davon erscheint am Ausgang S3 der Subtrahierstufe S ein Ausgangssignal, das ein Maß dafür ist, um wieviel das Eingangssignal am Eingang BE die positive bzw. negative Begrenzungsschwelle überschreitet. Dieses Ausgangssignal wird über die erste Multiplizierstufe M1 auf den ersten Eingang A21 der zweiten Addierstufe A2 geführt und gelangt über deren Ausgang A24 auf das Register R. Vom Ausgang RA des Registers R gelangt das Signal dann auf den dritten Eingang A23 der zweiten Addierstufe A2, so daß es dann zu dem am Eingang A21 ankommenden Ausgangssignal der Multiplizierstufe M1 hinzuaddiert wird. Die Addierstufe A2 und das Register R bilden somit einen Akkumulator, welcher das vom Ausgang S3 der Subtrahierstufe S kommende Signal zeitlich akkumuliert oder integriert.

Die Multiplizierstufe M1 multipliziert das Ausgangssignal der Subtrahierstufe S mit einem Koeffizienten K1, mit welchem vorbestimmt oder gewählt werden kann, mit welcher Stärke das Ausgangssignal der Subtrahierstufe S in den Akkumuliervorgang gegeben wird.

Die Multiplizierstufe M2 multipliziert das vom Ausgang RA des Registers R zum Eingang A22 der Addierstufe A2 rückgeführte Signal mit einem Koeffizienten K2, der zwischen 0 und -1 liegt.

Die Multiplizierstufe M3 multipliziert das vom Ausgang RA des Registers R zum Eingang A12 der ersten Addierstufe A1 geführte Signal mit einem Koeffizienten K3, mit dem vorbestimmbar oder einstellbar ist, mit welcher Stärke das akkumulierte Signal auf die erste Addierstufe A1 geführt und damit dem Videosignal hinzuaddiert wird, das auf den Eingang BE der Begrenzungsstufe B gegeben wird. Der Koeffizient K3 kann beliebig gewählt werden. Vorzugweise liegt er im Bereich zwischen 0 und + 1. Beispielsweise können die Koeffizienten K2 und K3 betragsmäßig gleich groß sein, d.h., K2 = -K3. Stellen die Koeffizienten glatte Zweierpotenzen dar, dann lassen sich die Multiplizierer im Falle von Binärzahlen durch eine einfache Binärstellenverschiebung realisieren.

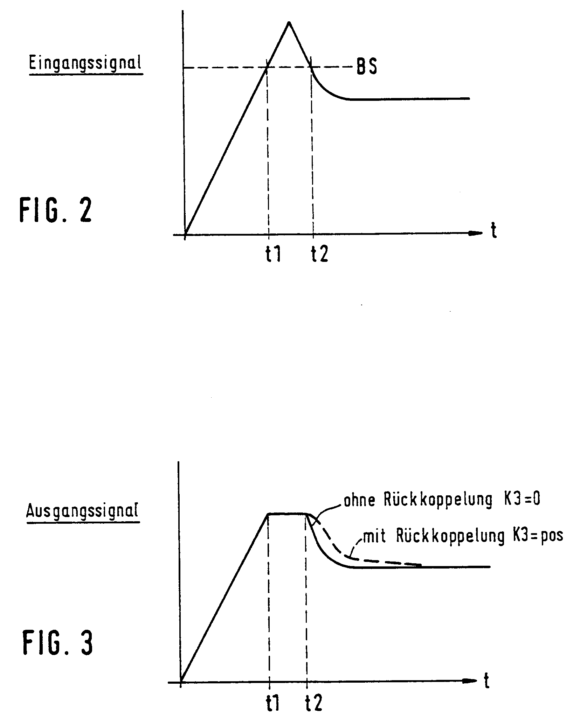

Unter Hinzunahme der Fig. 2 und 3 wird nun die Arbeitsweise des in Fig. 1 gezeigten Begrenzers erläutert.

Befindet sich das Eingangssignal der Begrenzungsstufe B im Zeitraum zwischen 0 und t1 unterhalb der Begrenzungsschwelle BS, sind Eingangssignal und Ausgangssignal gleich, so daß die Subtrahierstufe S kein Ausgangssignal abgibt. Die Akkumuliereinrichtung mit dem Register R und der Addierstufe A2 bleibt somit leer. Übersteigt das Eingangssignal zum Zeitpunkt t1 die Begrenzungsschwelle BS (wobei zur Vereinfachung die Fig. 2 und 3 für einen harten Begrenzungseinsatz gezeigt sind), bleibt das Ausgangssignal der Begrenzungsstufe B auf einem der Begrenzungsschwelle BS entsprechenden Signalwert, bis das Eingangssignal zum Zeitpunkt t2 die Begrenzungsschwelle BS wieder unterschreitet. Während des Zeitraums zwischen t1 und t2 ist der Wert des Eingangssignals größer als der Wert des Ausgangssignals, so daß am Ausgang S3 der Subtrahierstufe S ein Ausgangssignal entsteht, das dem Betrag, um welchen das Eingangssignal die Begrenzungsschwelle BS überschreitet, entspricht. Dieses Ausgangssignal der Subtrahierstufe S wird nach Multiplikation mit dem Koeffizienten K1 mittels der Akkumuliereinrichtung A2, R akkumuliert. Das akkumulierte Signal wird umso größer, je stärker und je länger die Begrenzungsschwelle BS von dem Eingangssignal überschritten wird. Das akkumulierte Signal stellt somit ein Maß für Dauer und Stärke der Überschreitung der Begrenzungsschwelle BS dar. Die Akkumulatoreinrichtung A2, R übt somit eine "Gedächtnisfunktion" aus, mittels welcher der Energieinhalt des von der Begrenzungsstufe B abgeschnittenen Signalanteils festgehalten wird.

Aufgrund des negativen Koeffizienten K2 der Multiplizierstufe M2 wird laufend ein Bruchteil des akkumulierten Signals von dem zu akkumulierenden Signal subtrahiert. Damit trotz dieses Subtrahiervorgangs während eines Begrenzungseinsatzes eine Akkumulation des abgeschnittenen Signalanteils stattfinden kann, muß derjenige Anteil des akkumulierten Signals, der beim Akkumuliervorgang subtrahiert wird, kleiner sein als derjenige Signalanteil, welcher beim Akkumuliervorgang addiert wird. Für den Fall, daß, wie bei dem in Fig. 1 dargestellten Beispiel, das akkumulierte Signal vom Ausgang RA des Registers R unverändert auf den Eingang A23 der Addierstufe A2 geführt wird, muß der Koeffizient K2 der Multiplizierstufe M2 der Bedingung

$$0 < K2 < -1$$

genügen.

Würde aus irgendeinem Grund das akkumulierte Ausgangssignal über die in Fig. 1 rechte Rückkopplungsschleife nicht mit dem Koeffizienten 1 sondern irgendeinem anderen Koeffizienten auf die Addierstufe A2 zurückgeführt, müßte der Koeffizient K2 entsprechend angepaßt werden. Allgemein gilt, daß über die in Fig. 1 links dargestellte Rückkopplung über die Multiplizierstufe M2 eine "Leckwirkung" für den Akkumuliervorgang auftreten soll, die schwächer ist als der über die in Fig. 1 rechte Rückkopplungsschleife gebildete Akkumuliervorgang.

Ist der Begrenzungseinsatz beendet, so daß am Eingang BE und am Ausgang BA der Begrenzungsstufe B wieder gleiche Signalwerte auftreten, hört das Ausgangssignal der Subtrahierstufe S auf. Das bis dahin akkumulierte Signal steht aber noch am Ausgang RA des Registers R an und wird über die Multiplizierstufe M3 und die Addierstufe A1 dem zu verarbeitenden digitalen Videosignal hinzuaddiert. Aufgrund der "Leckwirkung" der Multiplizierstufe M2 mit dem negativen Koeffizienten K2 vermindert sich der akkumulierte Signalwert allmählich. Über die Multiplizierstufe M3 und die Addierstufe A1 wird daher dem zu verarbeitenden Videosignal ein Signalanteil hinzuaddiert, welcher dem aufgrund der Leckwirkung abnehmenden akkumulierten Signalwert unter Berücksichtigung des Koeffizienten K3 entspricht. Nach Beendigung des Begrenzungseinsatzes wird also dem dann auftretenden Videosignal noch für eine bestimmte Zeitdauer ein Signalanteil hinzuaddiert, wobei Dauer und Stärke des hinzuaddierten Signals dem akkumulierten Signal am Ende des Begrenzungseinsatzes entsprechen. Je stärker und länger das Videosignal während des Begrenzungsvorgangs die Begrenzungsschwelle BS überschritten hat, umso stärker und länger ist der Signalanteil, der aufgrund der Gedächtnisfunktion dem Videosignal nach Beendigung des Begrenzungseinsatzes hinzuaddiert wird.

Dies ist in Fig. 3 graphisch veranschaulicht. Stünde die Gedächtnisfunktion der Akkumuliereinrichtung nicht zur Verfügung, würde ab dem Zeitpunkt t2 das Ausgangssignal mit dem Eingangssignal übereinstimmen. Dies ist in Fig. 3 mit einem durchgezogenen Signalverlauf gezeigt. Kann dagegen die Gedächtnisfunktion der Akkumuliereinrichtung wirksam werden, hat das Ausgangssignal vom Zeitpunkt t2 ab einen höheren Signalverlauf als das Eingangssignal. Dies ist in Fig. 3 mit einem gestrichelten Signalverlauf gezeigt.

Der Koeffizient K3 kann je nach Bedarf gewählt werden. Vorzugweise entspricht er der Bedingung

$$0 < K3 > 1.$$

Macht man K3 zu groß, wird unmittelbar nach Beendidigung des Begrenzungseinsatzes, also unmittelbar nach dem Zeitpunkt t2, ein zu großer Anteil des akkumulierten Signals zur Addierstufe A1 zurückgekoppelt und dem zu verarbeitenden Videosignal überlagert. Für diesen Fall kann der Begrenzungseinsatz aufgrund dieser Rückkopplung zu sehr verlängert werden. Macht man dagegen den Koeffizienten K3 zu klein, wird dem nach dem Begrenzungseinsatz auftretenden Videosignal ein zu kleiner Anteil des akkumulierten Signals hinzuaddiert, so daß die Gedächtniswirkung zu schwach ist, d.h., dem Signalverlauf nach dem Begrenzungseinsatz zu wenig von der zuvor gespeicherten Signalinformation überlagert wird.

Mit der erfindungsgemäßen Lösung ist ein digitaler Begrenzer für in digitaler Form vorliegende Videosignale verfügbar gemacht worden, der sich durch äußerst große Flexibilität bei der Dimensionierung und Einstellung auszeichnet. Einerseits kann man, beispielsweise durch Einsatz einer ROM-Tabelle für die Begrenzungsstufe B, eine beliebig geformte Begrenzungskennlinie realisieren. Andererseits kann man durch die Auswahl der Koeffizienten der Multiplizierstufen M1 bis M3 beliebige Charakteristiken der Akkumulier-und Gedächtnisfunktion realisieren. Es ist auch problemlos, beispielsweise die beiden Multiplizierstufen M2 und M3 mit veränderbaren Koeffizienten K2 bzw. K3 zu realisieren, was dem Benutzer eines mit dem erfindungsgemäßen Begrenzer ausgerüsteten Videorecorders gestatten würde, die Gedächtnisfunktion nach seiner Wahl einzustellen, um bei der Wiedergabe auf dem Bildschirm einen Bildcharakter nach seinem Geschmack zu erreichen.

**Patentansprüche**

1. Verfahren zur Pegelbegrenzung eines in digitaler Form vorliegenden Videosignals mittels einer Begrenzungsstufe (B) vorbestimmter Begrenzungscharakteristik,

dadurch **gekennzeichnet**,

daß ab Begrenzungseinsatz das Begrenzungsstufenausgangssignal von dem Begrenzungsstufeneingangssignal subtrahiert und das resultierende digitale Differenzsignal zeitlich akkumuliert wird,

daß das akkumulierte Signal mit einem vorbestimmten ersten Koeffizienten (K3) multipliziert und das resultierende Produktsignal dem zu begrenzenden Signal hinzuaddiert wird, so daß nach Ende eines Begrenzereinsatzes der Betrag der Ausgangsamplitude des Begrenzers gegenüber dem Betrag des vorliegenden Videosignals vergrößert wird,

und daß das akkumulierte Signal mit einem vorbestimmten zweiten Koeffizienten (K2) multipliziert und das resultierende Produktsignal von dem zu akkumulierenden Signal subtrahiert wird, um nach dem Ende eines Begrenzereinsatzes das akkumulierte Signal allmählich auf Null zurückzuführen.

2. Verfahren nach Anspruch 1, dadurch gekennzeichnet, daß das Differenzsignal vor der Akkumulation mit einem vorbestimmten dritten Koeffizienten (K1) multipliziert wird.

3. Verfahren nach Anspruch 1 oder 2, dadurch gekennzeichnet, daß ein erster Koeffizient (K3) verwendet wird, der zwischen 0 und +1 liegt.

4. Verfahren nach mindestens einem der Ansprüche 1 bis 3, dadurch gekennzeichnet, daß ein zweiter Koeffizient (K2) verwendet wird der zwischen 0 und -1 liegt, und daß das resultierende Produktsignal zum zu akkummulierenden Signal hinzuaddiert wird.

5. Verfahren nach mindestens einem der Ansprüche 1 bis 4, dadurch gekennzeichnet, daß der erste und der zweite Koeffizient (K3, K2) betragsmäßig gleich groß sind und der erste Koeffizient (K3) positiv und der zweite Koeffizient (K2) negativ ist.

6. Verfahren nach mindestens einem der Ansprüche 1 bis 5, dadurch gekennzeichnet, daß die Begrenzungscharakteristik einer Begrenzungskennlinie entspricht, die bis zum Begrenzungseinsatz einen Austiegswinkel von 45° und ab Begrenzungseinsatz einen Anstiegswinkel von kleiner als 45° aufweist.

7. Verfahren nach mindestens einem der Ansprüche 1 bis 6, dadurch gekennzeichnet, daß eine Begrenzungscharakteristik verwendet wird, die einer Begrenzungskennlinie mit weichem Begrenzungseinsatz entspricht.

8. Verfahren nach mindestens einem der Ansprüche 1 bis 7, dadurch gekennzeichnet, daß zur Bildung der Begrenzungscharakteristik eine ROM-Tabelle verwendet wird.

9. Digitaler Begrenzer zur Pegelbegrenzung eines in Digitalform vorliegenden Videosignals mit einer Begrenzungsstufe (B) vorbestimmter Begrenzungscharakteristik,
dadurch **gekennzeichnet**,
daß eine Subtrahierstufe (S) vorgesehen ist, in der ab Begrenzungseinsatz das Begrenzungsstufenausgangssignal von dem Begrenzungsstufeneingangssignal subtrahiert und ein digitales Differenzsignal mit dem Vorzeichen des Eingangssignals erzeugt wird,
daß eine Akkumulierstufe (A2, R) vorgesehen ist, welche das über ihren ersten Eingang (A21) zugeführte Differenzsignal zeitlich akkumuliert,
daß der Begrenzungsstufe (B) eine erste Addierstufe (A1) vorgeschaltet ist, die einen mit dem Videosignal beaufschlagten ersten Eingang (A11) und einen zweiten Eingang (A12) aufweist, und
daß der Ausgang (RA) der Akkumulierstufe (A2, R) über eine erste Multiplizierstufe (M3) mit dem zweiten Eingang (A12) der ersten Addierstufe (A1) und über eine zweite Multiplizierstufe (M2) mit einem zweiten Eingang (A22) der Akkumulierstufe (A2, R) gekoppelt ist,
wobei das Ausgangssignal der Akkumulierstufe (A2, R) von der ersten Multiplizierstufe (M3) mit einem ersten Koeffizienten (K3) positiven Vorzeichens und von der zweiten Multiplizierstufe (M2) mit einem zweiten Koeffizienten (K2) negativen Vorzeichens multipliziert und in der Akkumulierstufe (A2, R) dem zugeführten Differenzsignal hinzuaddiert wird.

10. Begrenzer nach Anspruch 9, dadurch gekennzeichnet, daß der zweite Koeffizient (K2) zwischen 0 und -1 liegt.

11. Begrenzer nach Anspruch 9 oder 10, dadurch gekennzeichnet, daß zwischen die Subtrahierstufe (S) und den Eingang der Akkumulierstufe (A2, R) eine dritte Multiplizierstufe (M1) geschaltet ist, die das Differenzsignal mit einem dritten Koeffizienten (K1) multipliziert.

12. Begrenzer nach mindestens einem der Ansprüche 9 bis 11, dadurch gekennzeichnet, daß der erste und der zweite Koeffizient (K3, K2) bei entgegengesetztem Vorzeichen gleichen Betrag aufweisen.

13. Begrenzer nach mindestens einem der Ansprüche 9 bis 12, dadurch gekennzeichnet, daß die Akkumulierstufe (A2, R) ein Register (R) und eine dem Eingang (RE) des Registers (R) vorgeschaltete zweite Addierstufe (A2) mit drei Eingängen (A21, A22, A23) aufweist, von denen ein erster (A21) mit dem Ausgang der Subtrahierstufe (S), ein zweiter mit dem Ausgang (RA) des Registers (R) und ein dritter mit dem Ausgang der zweiten Multiplizierstufe (M2) gekoppelt ist.

14. Begrenzer nach mindestens einem der Ansprüche 9 bis 13, dadurch gekennzeichnet, daß die Begrenzungsstufe (B) eine Begrenzungscharakteristik aufweist, die einer Begrenzungskennlinie mit einem Kennlinienanstieg von 45° bis zum Begrenzungseinsatz entspricht.

15. Begrenzer nach mindestens einem der Ansprüche 9 bis 14, dadurch gekennzeichnet, daß die Begrenzungsstufe (B) eine Begrenzungscharakteristik mit weichem Begrenzungseinsatz aufweist.

16. Begrenzer nach mindestens einem der Ansprüche 9 bis 15, dadurch gekennzeichnet, daß die Begrenzungsstufe (B) durch eine ROM-Tabelle realisiert ist.

17. Videorecorder mit digitaler Videosignalverarbeitung, **gekennzeichnet** durch einen digitalen Begrenzer nach mindestens einem der Ansprüche 9 bis 16.

18. Videorecorder nach Anspruch 17, dadurch gekennzeichnet, daß der digitale Begrenzer einem Frequenzmodulator zur frequenzmodulierten Aufzeichnung eines Videosignals in Digitalform vorgeschaltet ist.

19. Videorecorder nach Anspruch 18, dadurch gekennzeichnet, daß dem Frequenzmodulator eine Preemphasis-Einrichtung zugeordnet ist.

**Claims**

1. A method of limiting the level of a video signal present in digital form by means of a limiter stage (B) having a predetermined limiting characteristic,

**characterized in**

that from the start of limiting action, the limiter stage output signal is subtracted from the limiter stage input signal, and the resulting digital difference signal is accumulated over time,

that the accumulated signal is multiplied by a predetermined first coefficient (K3), and the resulting product signal is added to the signal to be limited, so that after the end of a limiting action, the magnitude of the output amplitude of the limiter is increased in relation to the magnitude of the video signal, and

that the accumulated signal is multiplied by a predetermined first coefficient (K3), and the resulting product signal is subtracted from the signal to be accumulated so as to gradually return the accumulated signal to zero after the end of a limiting action.

2. A method as claimed in claim 1, characterized in that prior to the accumulation, the difference signal is multiplied by a predetermined third coefficient (K1).

3. A method as claimed in claim 1 or 2 characterized in that use is made of a first coefficient (K3) lying between 0 and +1.

4. A method as claimed in any one of claims 1 to 3, characterized in that use is made of a second coefficient (K2) lying between 0 and -1, and that the resulting product signal is added to the signal to be accumulated.

5. A method as claimed in any one of claims 1 to 4, characterized in that the first and second coefficients (K3, K2) are equal in magnitude, with the first coefficient (K3) being positive and the second coefficient (K2) negative.

6. A method as claimed in any one of claims 1 to 5, characterized in that the limiting characteristic corresponds to a limiting characteristic which has an angle of 45° up to the start of limiting action and an angle of less than 45° from the start of limiting action.

7. A method as claimed in any one of claims 1 to 6, characterized in that the limiting characteristic is a soft-limiting characteristic.

8. A method as claimed in any one of claims 1 to 7, characterized in that a ROM table is used for forming the limiting characteristic.

9. A digital limiter for limiting the level of a video signal present in digital form, comprising a limiter stage (B) having a predetermined limiting characteristic,

**characterized in**

that a subtracting stage (S) is provided in which from the start of limiting action, the limiter stage output signal is subtracted from the limiter stage input signal to generate a digital difference signal having the sign of the input signal,

that an accumulating stage (A2, R) is provided which accumulates the difference signal, applied to it through its first input (A21), over time,

that the limiter stage (B) is preceded by a first adding stage (A1) having a first input (A11) and a second input (A12), said first input (A11) being fed with the video signal, and

that the output (RA) of the accumulating stage (A2, R) is coupled through a first multiplier stage (M3) to the second input (A12) of the first adding stage (A1) and through a second multiplier stage (M2) to a second input (A22) of the accumulating stage (A2, R), with the output signal from the accumulating stage (A2, R) being multiplied in the first multiplier stage (M3) by a first coefficient (K3) of positive sign and in the second multiplier stage (M2) by a second coefficient (K2) of negative sign, and added in the accumulating stage (A2, R) to the applied difference signal.

10. A limiter as claimed in claim 9, characterized in that the second coefficient (K2) lies between 0 and -1.

11. A limiter as claimed in claim 9, characterized in that between the subtracting stage (S) and the input of the accumulating stage (A2, R), a third multiplier stage (M1) is connected which multiplies the difference signal by a third coefficient (K1).

12. A limiter as claimed in at least one of claims 9 to 11,
characterized in that the first and second coefficients (K3, K2) are equal in magnitude and opposite in sign.

13. A limiter as claimed in at least one of claims 9 to 12,
characterized in that the accumulating stage (A2, R) comprises a register (R) and a second adding stage (A2) connected ahead of the register (R) and having three inputs (A21, A22, A23), a first (A21) of which is connected to the output of the subtracting stage (S), a second of which is connected to the output (RA) of the register (R), and a third of which is connected to the output of the second multiplier stage (M2).

**14.** A limiter as claimed in at least one of claims 9 to 13,
characterized in that the limiter stage (B) has a limiting characteristic which corresponds to a limiting characteristic rising at an angle of 45° up to the start of limiting action.

**15.** A limiter as claimed in at least one of claims 9 to 14,
characterized in that the limiter stage (B) has a soft-limiting characteristic.

**16.** A limiter as claimed in at least one of claims 9 to 15,
characterized in that the limiter stage (B) is implemented with a ROM table.

**17.** A video recorder with digital video-signal-processing circuitry, **characterized by** a digital limiter as claimed in at least one of claims 9 to 16.

**18.** A video recorder as claimed in claim 17, characterized in that the digital limiter is connected ahead of a frequency modulator for frequency-modulation recording of a video signal in digital form.

**19.** A video recorder as claimed in claim 18, characterized in that a preemphasis device is associated with the frequency modulator.

**Revendications**

**1.** Procédé pour limiter le niveau d'un signal vidéo présent sous forme numérique, à l'aide d'un étage limiteur (B) possédant une caractéristique de limitation prédéterminée,
caractérisé en ce qu'à partir de l'activation de la limitation, le signal de sortie de l'étage limiteur est soustrait du signal d'entrée de l'étage limiteur et le signal de différence numérique résultant est cumulé dans le temps,
que le signal cumulé est multiplié par un premier coefficient prédéterminé (K3) et que le signal produit résultant est ajouté au signal devant être limité, de sorte qu'à la fin d'une activation du limiteur, la valeur absolue de l'amplitude de sortie du limiteur est accrue par rapport à la valeur absolue du présent signal vidéo, et
que le signal cumulé est multiplié par un second coefficient déterminé (K2) et que le signal produit résultant est soustrait du signal cumulé, afin de ramener progressivement à zéro le signal cumulé, à la fin d'une activation du limiteur.

**2.** Procédé selon la revendication 1, caractérisé en ce que le signal de différence est multiplié, avant le cumul, par un troisième coefficient prédéterminé (K1).

**3.** Procédé selon la revendication 1 ou 2, caractérisé en ce qu'on utilise un premier coefficient (K3), qui est compris entre 0 et +1.

**4.** Procédé selon au moins l'une des revendications 1 à 3, caractérisé en ce qu'on utilise un second coefficient (K2), qui est compris entre 0 et -1, et que le signal produit résultant est ajouté au signal devant être cumulé.

**5.** Procédé selon l'une des revendications 1 à 4, caractérisé en ce que les premier et second coefficients (K3, K2) possèdent une même valeur absolue et que le premier coefficient (K3) est positif et que le second coefficient (K2) est négatif.

**6.** Procédé selon l'une des revendications 1 à 5, caractérisé en ce que la caractéristique de limitation correspond à une courbe caractéristique de limitation, qui possède un angle de montée de 45° jusqu'à l'activation de la limitation et un angle de montée inférieur à 45° à partir de l'activation de la limitation.

**7.** Procédé selon au moins l'une des revendications 1 à 6, caractérisé en ce qu'on utilise une caractéristique de limitation, qui correspond à la courbe caractéristique de limitation avec activation en douceur de la limitation.

**8.** Procédé selon au moins l'une des revendications 1 à 7, caractérisé en ce qu'on utilise un tableau ROM pour la formation de la caractéristique de limitation.

**9.** Limiteur numérique servant à limiter le niveau d'un signal vidéo présent sous forme numérique, comportant un étage limiteur (B) possédant une caractéristique de limitation prédéterminée, caractérisé en ce
qu'il est prévu un étage soustracteur (S), dans lequel, à partir de l'activation de la limitation, le signal de sortie de l'étage limiteur est soustrait du signal d'entrée de l'étage limiteur, et un signal de différence numérique possédant le signe du signal d'entrée est produit,
qu'il est prévu un étage accumulateur (A2, R), qui cumule dans le temps le signal de différence envoyé par l'intermédiaire de la première entrée (A21) de cet étage,

qu'en amont de l'étage limiteur (B) est branché un premier étage additionneur (A1), qui possède une première entrée (A11), chargée par le signal vidéo, et une seconde entrée (A12),

que la sortie (RA) de l'étage accumulateur (A2, R) est couplée, par l'intermédiaire d'un premier étage multiplicateur (M3), à la seconde entrée (A12) du premier étage additionneur (A1) et, par l'intermédiaire d'un second étage multiplicateur (M2), à une seconde entrée (A22) de l'étage accumulateur (A2, R),

le signal de sortie de l'étage accumulateur (A2, R) étant multiplié, dans le premier étage multiplicateur (M3), par un premier coefficient (K3) possédant un signe positif et, dans le second étage multiplicateur (M2), par un second coefficient (K2) possédant un signe négatif, et étant ajouté au signal de différence envoyé, dans l'étage accumulateur (A2; R).

10. Limiteur selon la revendication 9, caractérisé en ce que le second coefficient (K2) est compris entre 0 et -1.

11. Limiteur selon la revendication 9 ou 10, caractérisé en ce qu'entre l'étage soustracteur (S) et l'entrée de l'étage accumulateur (A2, R) est branché un troisième étage multiplicateur (M1), qui multiplie le signal de différence par un troisième coefficient (K1).

12. Limiteur selon au moins l'une des revendications 9 à 11, caractérisé en ce que les premier et second coefficients (K3, K2) possèdent une même valeur absolue et des signes opposés.

13. Limiteur selon au moins l'une des revendications 9 à 12, caractérisé en ce que l'étage accumulateur (A2, R) possède un registre (R) et un second étage additionneur (A2), qui est branché en amont de l'entrée (RE) du registre (R) et comporte trois entrées (21, A22, A23), parmi lesquelles une première entrée (A21) est reliée à la sortie de l'étage soustracteur (S), une seconde entrée est reliée à la sortie (R1) du registre (R) et une troisième entrée est reliée à la sortie du second étage multiplicateur (M2).

14. Limiteur selon au moins l'une des revendications 9 à 13, caractérisé en ce que l'étage limiteur (B) possède une caractéristique de limitation, qui correspond à une courbe caractéristique de limitation possédant une montée à 45° jusqu'à l'activation de la limitation.

15. Limiteur selon au moins l'une des revendications 9 à 14, caractérisé en ce que l'étage limiteur (B) possède une caractéristique de limitation avec activation en douceur de la limitation.

16. Limiteur selon au moins l'une des revendications 9 à 15, caractérisé en ce que l'étage limiteur (B) est réalisé au moyen d'un tableau ROM.

17. Enregistreur vidéo comportant une unité de traitement du signal vidéo, caractérisé par un limiteur numérique selon au moins l'une des revendications 9 à 16.

18. Enregistreur vidéo selon la revendication 17, caractérisé en ce que le limiteur numérique est branché en amont d'un modulateur de fréquence servant à enregistrer, d'une manière modulée en fréquence, un signal vidéo sous forme numérique.

19. Enregistreur vidéo selon la revendication 18, caractérisé en ce qu'un dispositif de préaccentuation est associé au modulateur de fréquence.

FIG. 1

FIG. 2

FIG. 3